# EUROPÄISCHE PATENTSCHRIFT

(11) **EP 2 132 579 B1**
(45) Veröffentlichungstag und Bekanntmachung des Hinweises auf die Patenterteilung: **10.05.2017**
(21) Anmeldenummer: 08707604.8
(22) Anmeldetag: 07.02.2008
(51) Int. Cl.: G01R 29/26

(54) **VERFAHREN UND VORRICHTUNG ZUM MESSEN DES PHASENRAUSCHENS**
METHOD AND DEVICE FOR MEASURING PHASE JITTER
PROCÉDÉ ET DISPOSITIF DE MESURE DU BRUIT DE PHASE

(30) Priorität: 13.03.2007 DE 102007012122
(43) Veröffentlichungstag der Anmeldung: 16.12.2009
(73) Patentinhaber: Rohde & Schwarz GmbH & Co. KG, 81671 München (DE)
(72) Erfinder: WENDLER, Wolfgang, 82194 Gröbenzell (DE); ROTH, Alexander, 84405 Dorfen (DE); ECKERT, Hagen, 86415 Mering (DE)
(74) Vertreter: Körfer, Thomas
(86) Internationale Anmeldenummer: PCT/EP2008/000955
(87) Internationale Veröffentlichungsnummer: WO 2008/110237

(56) Entgegenhaltungen:
- DE-A1- 10 114 410
- US-A- 5 179 344
- US-A1- 2005 238 094
- US-A1- 2006 209 942

## Beschreibung

Die Erfindung betrifft ein Verfahren und eine Vorrichtung zum Messen des Phasenrauschens eines Signals.

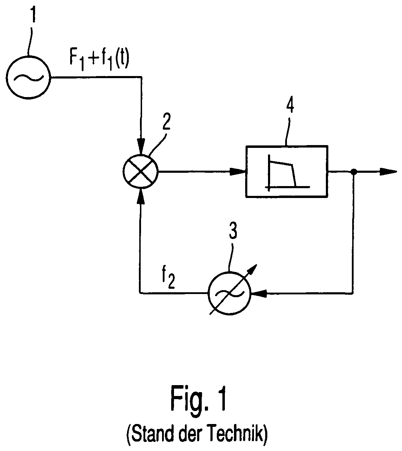

Das Phasenrauschen einer Signalquelle, beispielsweise eines Frequenzoszillators, wird gemäß dem Stand der Technik mit einer Vorrichtung entsprechend Fig. 1 gemessen:
Hierzu wird das von der Signalquelle 1 erzeugtes Frequenzsignal mit einer Grundfrequenz f₁ und einem dieser Grundfrequenz f₁ überlagerten Phasenrauschen f₁(t) in einem Mischer 2 mit dem von einer Referenz-Signalquelle 3 erzeugten Referenz-Frequenzsignal mit einer Grundfrequenz f₂ gemischt. Am Ausgang des Mischers 2 liegt ein Signalanteil mit einer Frequenz, die der Addition der Frequenzen des von der Signalquelle 1 erzeugten Frequenzsignals und des von der Referenz-Signalquelle 3 erzeugten Frequenzsignals entspricht, und ein Signalanteil mit einer Frequenz, die der Subtraktion der Frequenzen des von der Signalquelle 1 erzeugten Frequenzsignals und des von der Referenz-Signalquelle 3 erzeugten Frequenzsignals entspricht. In einem dem Mischer 3 nachfolgenden Tiefpassfilter 4 wird der Signalanteil mit der additiven Verknüpfung der Frequenzen der Signalquelle 1 und der Referenz-Signalquelle 3 ausgeblendet. Der Signalanteil der subtraktiven Verknüpfung der Frequenzen der Signalquelle 1 und der Referenz-Signalquelle 3 wird als Regeldifferenz eines Phasenregelkreises der gesteuerten Referenz-Signalquelle 3 zur Minimierung zugeführt. Im ausgeregeltem Zustand des Phasenregelkreises entspricht die Grundfrequenz f₂ des Referenz-Frequenzsignals der Grundfrequenz f₁ des Frequenzsignals, so dass am Ausgang des Tiefpassfilters 4 ein Signal mit einer dem Phasenrauschen f₁(t) entsprechenden Frequenz anliegt.

Nachteilig an einer derartigen Vorrichtung zum Messen des Phasenrauschens eines Signals ist die Tatsache, dass das von der Referenz-Signalquelle 3 erzeugte Referenz-Frequenzsignal auch mit einem Phasenrauschen f₂(t) belegt ist, das sich im Signal am Ausgang des Tiefpassfilters 4 zum Phasenrauschen f₁(t) der Signalquelle 1 unerwünschterweise überlagert.

Zur Überwindung dieses deutlichen Nachteils offenbart die Druckschrift US2005/0238094 A1 ein Verfahren und eine Vorrichtung zum Phasenrauschmessen, die auf einer Korrelationsanalyse basieren. Das von einer Signalquelle 100 erzeugte Mess-Signal V mit einer bestimmten zu vermessenden Frequenz f₁ und einem überlagerten Phasenrauschen f₁(t) wird in einem nachfolgenden Verteiler 105 auf ein erstes Mess-Signal V₁' in einem ersten Signalpfad und ein zweites Mess-Signal V₂' in einem zweiten Signalpfad aufgeteilt. Das erste bzw. zweite Mess-Signal V₁' bzw. V₂' wird jeweils in einem Mischer 180 bzw. 190 in ein erstes bzw. zweites Signal V₁ bzw. V₂ mit jeweils reduzierter Frequenz gewandelt. Die Mischerfrequenz des ersten und zweiten Mischers 180 und 190 werden jeweils von einem lokalen Oszillator 181 und 191 erzeugt.

Das erste Signal V₁ wird einem ersten Phasenregelkreises 110, bestehend aus einem ersten Mischer 111, einem nachfolgenden ersten Tiefpassfilter 112 und einer gesteuerten ersten Referenz-Signalquelle 113 entsprechend dem Phasenregelkreis in Fig. 1, zur Erzeugung eines dritten Signals *V*₃ mit einer gegenüber der ersten Frequenz (f₁+f₁(t))/N des ersten Signal V₁ um die Meßfrequenz f₁ kompensierten dritten Frequenz f₃(t) zugeführt. Die dritte Frequenz (f₃(t)) enthält das Phasenrauschen f₁(t) der Signalquelle 100 und das Phasenrauschen f₂₁(t) der gesteuerten ersten Referenz-Signalquelle 113. Das zweite Signal V₂ wird analog einem zweiten Phasenregelkreis 120, bestehend aus einem zweiten Mischer 121, einem nachfolgenden zweiten Tiefpassfilters 122 und einer gesteuerten zweiten Referenz-Signalquelle 123 zur Erzeugung eines vierten Signals *V*₄ mit einer gegenüber der zweiten Frequenz (f₁+f₁(t))/M des zweiten Signals V₂ um die Meßfrequenz f₁ kompensierten vierten Frequenz f₄(t) zugeführt. Die vierte Frequenz (f₄(t))enthält das Phasenrauschen f₁(t) der Signalquelle 100 und das Phasenrauschen f₂₂(t) der gesteuerten zweiten Referenz-Signalquelle 123.

Nach einer Analog-Digital-Wandlung des dritten Signals *V*₃ in einem ersten Analog-Digital-Wandler 150 und einer darauf aufsetzenden Fourier-Analyse des digitalisierten dritten Signals *V*₃ in einem ersten Fast-Fourier-Transformator 151 (Schneller Fourier Transformator) und entsprechend einer Analog-Digital-Wandelung des vierten Signals *V*₄ in einem zweiten Analog-Digital-Wandler 160 und einer darauf aufsetzenden Fourier-Analyse des digitalisierten vierten Signals *V*₄ in einem zweiten Fast-Fourier-Transformator 161 wird aus dem beiden Fourier-Spektren des dritten und vierten Signals *V*₃ und *V*₄ in einem nachfolgenden Korrelator 170 das zugehörige Korrelationsspektrum berechnet.

Eine den Korrelator 140 nachfolgende Mittelungseinheit 171 führt eine zeitliche Mittelung der im Korrelator 170 über ein hinlänglich langes Zeitintervall T berechneten Korrelationsspektren durch. Das Mittelungsergebnis enthält einzig die Spektralanteile des im dritten und vierten Signal *V*₃ und *V*₄ enthaltenen Phasenrauschens f₁(t) der Signalquelle 100, nicht aber die Spektralanteile des im dritten und vierten Signal *V*₃ und *V*₄ ebenfalls enthaltenen und nicht zueinander korrelierten Phasenrauschens f₂₁(t) und f₂₂(t) der gesteuerten ersten und zweiten Referenz-Signalquelle 113 und 123.

Der Einsatz eines Mischers zur Frequenzreduzierung im Hinblick auf eine frequenzmäßige Erweiterung des zu vermessenden Phasenrauschens f₁(t) innerhalb des begrenzten Frequenzmessbereichs des Korrelators stellt hierbei eine vergleichsweise teure Realisierung dar.

Die Druckschriften US 2006/0209942 A1 und DE 101 14 410 A1 offenbaren Verfahren und Vorrichtungen zum Messen des Phasenrauschens mit Frequenzteilen.

Die Aufgabe der Erfindung ist es deshalb, ein Verfahren und eine Vorrichtung zum Phasenrauschmessen eines Signals derart weiterzuentwickeln, dass die Frequenzreduzierung der beiden Mess-Signale im Hinblick auf eine frequenzmäßige Erweiterung des zu vermessenden Phasenrauschens f₁(t) innerhalb des begrenzten Frequenzmessbereichs des Korrelators möglichst aufwandsarm realisiert ist.

Die Erfindungsaufgabe wird durch ein erfindungsgemäßes Verfahren zum Messen des Phasenrauschens eines Signals mit den Merkmalen des Anspruchs 1 und durch eine erfindungsgemäße Vorrichtung zum Messen des Phasenrauschens eines Signals mit den Merkmalen des Anspruchs 7 gelöst.

Erfindungsgemäß wird die Frequenzreduzierung des ersten und zweiten Mess-Signals V₁' und V₂' anstelle eines Mischers mit einem Frequenzteiler realisiert. Die Lösung mittels eines Frequenzteilers benötigt keinen teuren lokalen Oszillator wie im Falle eines Mischers und ist somit deutlich günstiger.

Als Frequenzteiler werden für einen Teilungsfaktor von zwei und von ganzzahligen Vielfachen von zwei rückgekoppelte, flankengetriggerte Kippstufen, die in Abhängigkeit des zu realisierenden Teilungsfaktors zueinander kaskadiert werden.

Im allgemeinsten Fall erfolgt die Frequenzteilung der Frequenz f₁+f₁(t) des ersten Mess-Signals V₁' in eine erste Frequenz (f₁+f₁(t))/N, während die Frequenzteilung der Frequenz f₁+f₁(t) des zweiten Mess-Signals V₂' in eine zweite Frequenz (f₁+f₁(t))/M erfolgt.

Bei unterschiedlichen Teilungsfaktoren N und M wird ein Übersprechen des ersten oder zweiten Signals V₁ oder V₂ zwischen dem ersten und zweiten Signalpfad verhindert.

Bei identischen Teilungsfaktoren N und M müssen die Phasen des ersten und zweiten Signals V₁ und V₂, die jeweils das Phasenrauschen f₁(t) der Signalquelle beinhalten, synchronisiert werden, um das Korrelationsergebnis zur Bestimmung des Phasenrauschens f₁(t) der Signalquelle durch einen Phasenversatz zwischen dem in die Korrelation mündenden dritten und vierten Signal *V*₃ und *V*₄ nicht zu verschlechtern. Eine Synchronisierung kann hierbei alternativ auf eine positive oder eine negative Flanke des in seiner Frequenz zu teilenden ersten und zweiten Mess-Signals V₁' und V₂' durchgeführt werden.

Zur Synchronisierung werden erfindungsgemäß die Phasen des ersten und zweiten Signals V₁ und V₂ am Ausgang des jeweiligen Frequenzteilers miteinander verglichen und im Fall einer Phasendifferenz Δϕ über eine Rücksetzlogik die einzelnen im jeweiligen Frequenzteiler kaskadierten Kippstufen über jeweils ihren Rücksetzeingang rückgesetzt. Diese gezielte synchrone Rücksetzung aller kaskadierten Kippstufen der beiden Frequenzteiler bedingt eine zueinander synchrone Phase des ersten und zweiten frequenzreduzierten Signals V₁ und V₂ am Ausgang des jeweiligen Frequenzteilers.

Eine Ausführungsform des erfindungsgemäßen Verfahrens und der erfindungsgemäßen Vorrichtung zum Messen des Phasenrauschens eines Signals mit dem folgenden anhand der Zeichnung im Detail erläutert. Die Figuren der Zeichnung zeigen:
- Fig. 1: ein Blockschaltbild einer Vorrichtung zur Messung des Phasenrauschens einer Signalquelle nach dem Stand der Technik,
- Fig. 2: ein Blockschaltbild einer Vorrichtung zur Messung des Phasenrauschens einer Signalquelle mittels Korrelationsanalyse nach dem Stand der Technik,
- Fig. 3: ein Blockschaltbild einer erfindungsgemäßen Vorrichtung zum Messen des Phasenrauschens eines Signals,
- Fig. 4A, 4B: ein Blockdiagramm eines Frequenzteilers mit Phasensynchronisierung bei positiver und negativer Flanke des Eingangsignals und
- Fig. 5: ein Flussdiagramm eines Verfahrens zum Messen des Phasenrauschens eines Signals.

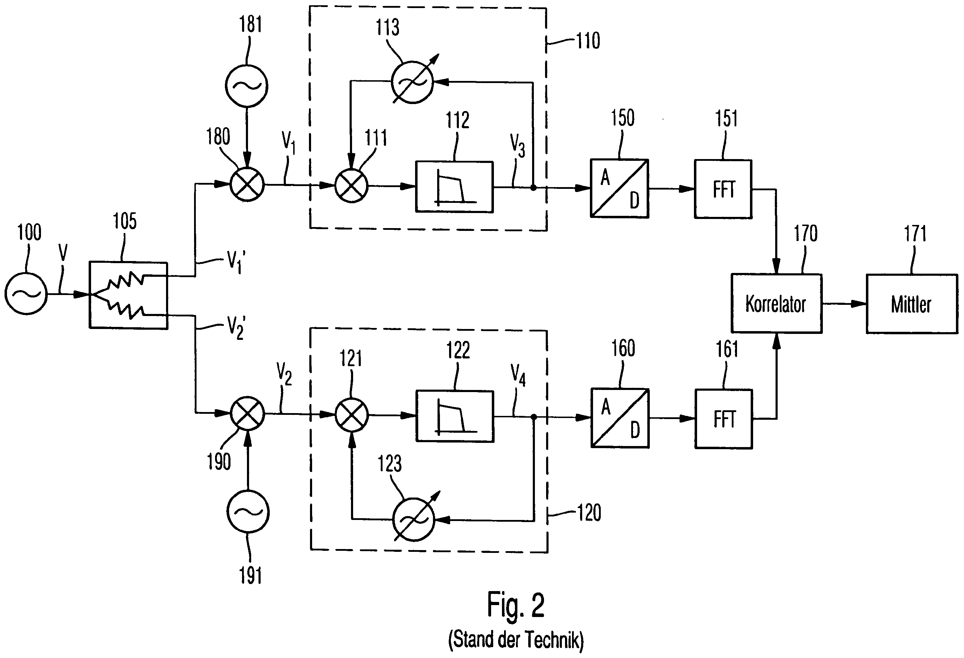

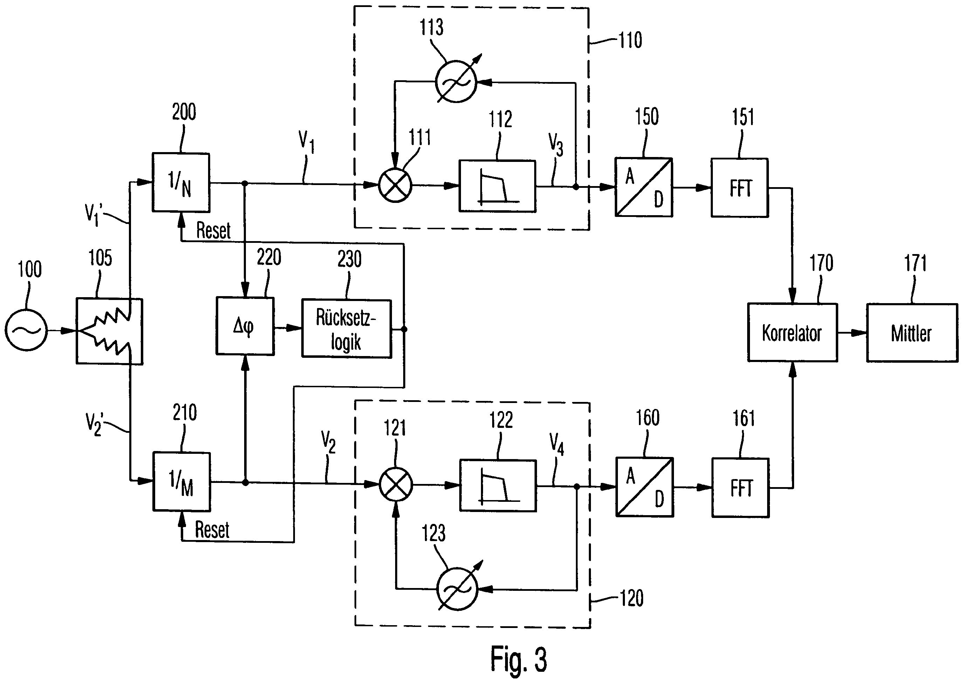

Die erfindungsgemäße Vorrichtung zum Messen des Phasenrauschens eines Signals in Fig. 3 enthält anstelle der ersten und zweiten Mischers 180 und 190 in der Vorrichtung zum Messen des Phasenrauschens eines Signals nach dem Stand der Technik in Fig. 2 jeweils einen ersten und zweiten Frequenzteiler 200 und 210. Die übrigen Vorrichtungsmerkmale der Vorrichtung zum Messen des Phasenrauschens eines Signals nach dem Stand der Technik sind auch in der erfindungsgemäßen Vorrichtung enthalten, weisen deshalb jeweils das gleiche Bezugszeichen auf und werden deshalb nicht mehr wiederholt beschrieben.

Der erste Frequenzteiler 200 teilt die Meßfrequenz *f*₁ und das überlagerte Phasenrauschen *f*₁(*t*) des ersten Mess-Signals V₁' an seinem Eingang um den ganz zahligen Teilungsfaktor N in eine erste Frequenz (*f*₁+*f*₁(*t*))/*N* des ersten Signals V₁ an seinem Ausgang. Analog teilt der zweite Frequenzteiler 210 die Meßfrequenz *f*₁ und das überlagerte Phasenrauschen *f*₁(*t*) des zweiten Mess-Signals V₂' an seinem Eingang um den ganz zahligen Teilungsfaktor M in eine zweite Frequenz (*f*₁+*f*₁(*t*))/*M* des zweiten Signals V₂ an seinem Ausgang.
Typischerweise aber nicht zwingend ist der Teilungsfaktor N des ersten Frequenzteilers 200 unterschiedlich zum Teilungsfaktor M des zweiten Frequenzteilers 210, um ein Übersprechen des ersten und zweiten Signals V₁ und V₂ zwischen dem ersten und zweiten Signalpfad zu verhindern. Von der Erfindung ist aber auch der Fall eines identischen Teilungsfaktors N und M des ersten und zweiten Frequenzteilers 200 und 210 abgedeckt.

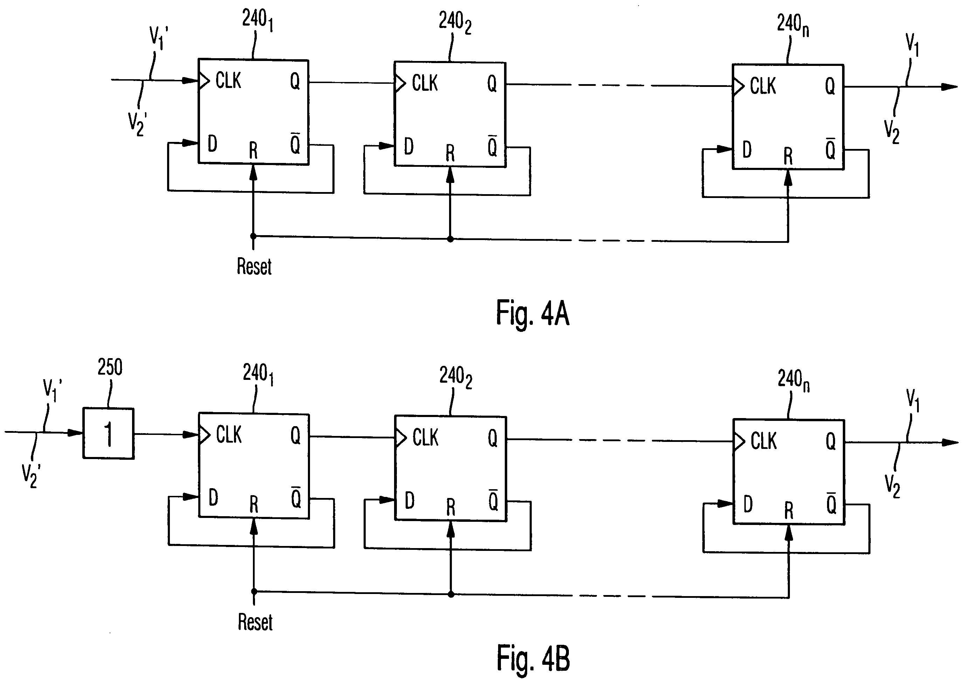

Der Frequenzteiler 200 und 210 besteht bei einer ersten Ausführungsform mit einer Triggerung bei einer positiven Flanke des ersten bzw. zweiten Mess-Signals V₁' bzw. V₂' gemäß Fig. 4A und bei einer zweiten Ausführungsform mit einer Triggerung bei einer negativen Flanke des ersten bzw. zweiten Mess-Signals V₁' bzw. V₂' gemäß Fig. 4B aus mindestens einer rückgekoppelten, flankengetriggerten Kippstufe - so genanntes D-Flip-Flop -, das jeweils eine Frequenzteilung um den Teilungsfaktor zwei durchführt. Bei einem Teilungsfaktor von einem ganzzahligen Vielfachen von zwei ist eine dem Teilungsfaktor entsprechende Anzahl von rückgekoppelten flankengetriggerten Kippstufen 240₁,240₂, ...,240ₙ zueinander zu kaskadieren.

Bei einer Triggerung der Frequenzteiler 200 und 210 mit einer negativen Flanke des ersten bzw. zweiten Mess-Signals V₁' bzw. V₂' gemäß Fig. 4B ist der ersten rückgekoppelten flankengetriggerten Kippstufe 240₁ ein Invertierer 250 vorzuschalten, der die jeweils negativen Flanken des ersten bzw. zweiten Mess-Signals V₁' bzw. V₂' zu positiven Flanken invertiert und damit die Verwendung eines Frequenzteilers mit einer Triggerung bei einer positiven Flanke des ersten bzw. zweiten Mess-Signals V₁' bzw. V₂' gemäß Fig. 4A ermöglicht.
Neben der Frequenzteilung erfolgt im ersten und zweiten Frequenzteiler 200 und 210 auch eine Synchronisierung der Phasen des frequenzreduzierten ersten und zweiten Signals V₁ bzw. V₂ am jeweiligen Ausgang des ersten und zweiten Frequenzteilers 200 und 210. Hierzu werden die beiden Phasen des frequenzreduzierten ersten und zweiten Signals V₁ bzw. V₂ am Ausgang des ersten und zweiten Frequenzteilers 200 und 210 in einem Phasenvergleicher 220 miteinander verglichen. Liegt eine Phasenabweichungen Δϕ zwischen den beiden Phasen vor, so wird in einer dem Phasenvergleicher 220 nachfolgenden Rücksetzlogik 230 ein Rücksetzsignal Reset zum Rücksetzen aller rückgekoppelten, flankengetriggerten Kippstufen generiert, die jeweils im ersten und zweiten Frequenzteiler 200 und 210 miteinander kaskadiert sind. Die Funktionsweise der Rücksetzlogik 230 basiert im wesentlichen auf einer Aktivierung des Rücksetzsignal Reset im Fall einer Überschreitung eines Schwellwerts durch die Phasenabweichung Δϕ.

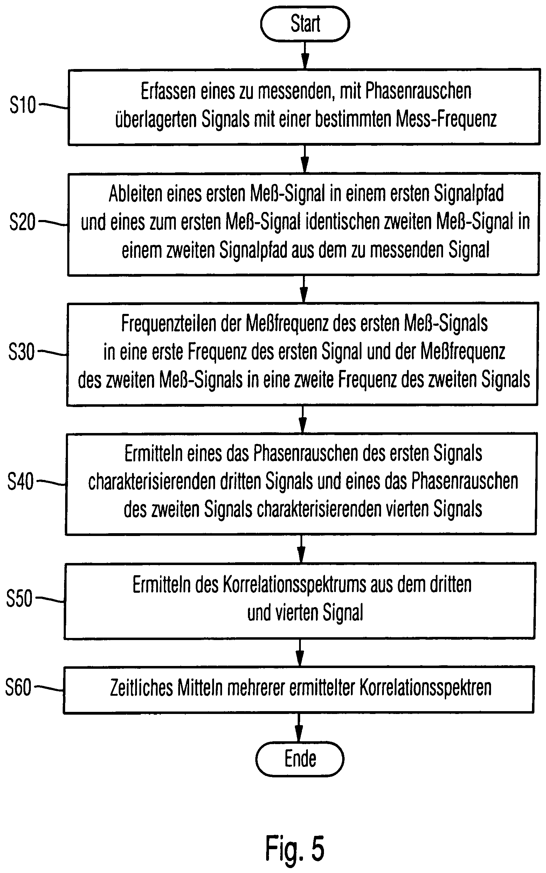

Im folgenden wird ein Verfahren zum Messen des Phasenrauschens eines Signals anhand des Flussdiagramms in Fig. 5 beschrieben.

Im ersten Verfahrensschritt S10 des Verfahrens wird das Mess-Signal V mit einer bestimmten Meßfrequenz f₁ erfasst, dem ein Phasenrauschen f₁(t) überlagert ist.
Im nächsten Verfahrenschritt S20 wird das zu messendes Signale V in einem Verteiler 105 in ein erstes Mess-Signal V₁' in einem ersten Signalpfad und ein zum ersten Mess-Signal V₁' näherungsweise identisches zweites Mess-Signal V₂' in einem zweiten Signalpfad aufgeteilt.
Der darauffolgende Verfahrenschritt S30 beinhaltet die Frequenzteilung der Frequenz f₁+f₁(t) des ersten Mess-Signals V₁' um den Teilungsfaktor N in eine erste Frequenz (f₁+f₁(t))/N des ersten Signals V₁ in einem ersten Frequenzteiler 200 und analog die Frequenzteilung der Frequenz f₁+f₁(t) des zweiten Mess-Signals V₂' um den Teilungsfaktor M in eine zweite Frequenz (f₁+f₁(t))/M des zweiten Signals V₂ in einem zweiten Frequenzteiler 210.
Die Höhe der Teilungsfaktoren N und M wird derart festgelegt, dass einerseits der durch eine Frequenzänderung Δ*f*₁ der Signalquelle 100 bedingte Phasenhub in einem nachfolgenden ersten und zweiten Phasenregelkreis 110 und 120 keine Übersteuerung des Phasenkomparators 111 und 121 und kein erfolgloses Einregeln des jeweiligen Phasenregelkreises 110 und 120 bewirkt und andererseits die Frequenzen des dritten und vierten Signals *V*₃ und *V*₄ im Frequenzbereich des ersten und zweiten Fast-Fourier-Transformators 151 und 161 zu liegen kommen.

Im nächsten Verfahrenschritt S40 wird aus dem frequenzreduzierten ersten bzw. zweiten Signal V₁ bzw. V₂ in einem nachfolgenden ersten bzw. zweiten Phasenregelkreis 110 bzw. 120 ein das Phasenrauschen f₁(t) der Signalquelle 100 charakterisierendes drittes bzw. viertes Signal *V*₃ und *V*₄ ermittelt, dem zusätzlich das Phasenrauschen f₂₁(t) bzw. f₂₂(t) des ersten bzw. zweiten Mischers 111 bzw. 121 des ersten bzw. zweiten Phasenregelkreises 110 bzw. 120 überlagert ist.

Nach einer Analog-Digital-Wandelung in einem ersten und zweiten Analog-Digital-Wandler 150 und 160 und einer Fourier-Analyse in einem ersten und zweiten Fast-Fourier-Transformator 151 und 161 werden die Fourier-Spektren des dritten und vierten Signals *V*₃ und *V*₄ im nächsten Verfahrensschritt S50 einem Korrelator 170 zur Ermittlung des Korrelationsspektrums anhand einer Korrelationsanalyse zugeführt.

Nach der Berechnung mehrerer Korrelationsspektren über ein bestimmtes Zeitintervall T werden im abschließenden Verfahrenschritt S60 die berechneten Korrelationsspektren einer Mittelung in einem Mittler 171 zugeführt. Bei Mittelung der Korrelationsspektren über ein hinlänglich langes Zeitintervall T heben sich die Spektralanteile des zueinander nicht korrelierten Phasenrauschens f₂₁(t) und f₂₂(t) des ersten und zweiten Mischers 111 und 121 im ersten und zweiten Phasenregelkreises 110 und 120, insbesondere das Phasenrauschen des ersten und zweiten Frequenzteilers 200 und 210 gegenseitig im gemittelten Korrelationsspektrum auf. Das gemittelte Korrelationsspektrum enthält somit korrekterweise nur noch - in Verstärkung - die Spektralanteile des Phasenrauschens f₁(t) der Signalquelle 100.

Die Erfindung ist nicht auf die dargestellte Ausführungsform des erfindungsgemäßen Verfahrens und der erfindungsgemäßen Vorrichtung zum Messen des Phasenrauschens eines Signals beschränkt. Die Erfindung deckt auch andere hier nicht beschriebene Realisierungsvarianten eines Frequenzteilers, insbesondere Realisierungsvarianten eines Frequenzteilers mit einem Teilungsfaktor ungleich von zwei und ungleich einem ganzzahligen Vielfachen von zwei, ab.

## Patentansprüche

1. Verfahren zum Messen des Phasenrauschens eines Signals mit folgenden Verfahrensschritten:
• Erfassen eines Mess-Signals (V) mit einer bestimmten Mess-Frequenz (f₁) und mit einem überlagerten Phasenrauschen (f₁(t)),
• Aufteilen des Mess-Signals (V) in ein erstes Mess-Signal (V₁') und ein zweites Mess-Signal (V₂') jeweils mit der bestimmten Mess-Frequenz (f₁) und mit dem überlagerten Phasenrauschen (f₁(t)),
• Ableiten eines ersten Signals (V₁) aus dem ersten Mess-Signal (V₁') mit einer durch Frequenzreduzierung gegenüber der Mess-Frequenz (f₁) und dem überlagerten Phasenrauschen (f₁(t)) reduzierten ersten Frequenz ((f₁+f₁(t)))/N,
• Ableiten eines zweiten Signals (V₂) aus dem zweiten Mess-Signal (V₂') mit einer durch Frequenzreduzierung gegenüber der Mess-Frequenz (f₁) und dem überlagerten Phasenrauschen (f₁(t)) reduzierten zweiten Frequenz ((f₁+f₁(t)/M),
• Ermitteln eines dritten Signals (*V*₃) mit einer gegenüber der ersten Frequenz ((f₁+f₁(t))/N) des ersten Signal (V₁) um die Meßfrequenz (f₁) kompensierten dritten Frequenz (f₃(t)),
• Ermitteln eines vierten Signals (*V*₄) mit einer gegenüber der zweiten Frequenz ((f₁+f₁(t))/M) des zweiten Signals (V₂) um die Meßfrequenz (f₁) kompensierten vierten Frequenz (f₄(t)),
• Ermitteln eines Korrelationsspektrums mit einem Frequenzbereich aus dem dritten und vierten Signal (*V*₃,*V*₄),
**dadurch gekennzeichnet,**
**dass** die Frequenzreduzierung mittels Frequenzteilen der Frequenz (f₁+f₁(t)) des ersten und zweiten Mess-Signals (V₁',V₂') durch einen ersten bzw. zweiten Frequenzteiler (200, 210), die jeweils mindestens eine kaskadierte rückgekoppelte flankengesteuerte Kippstufe (240₁ bis 240ₙ) aufweisen, erfolgt, so dass die dritte und vierte Frequenz (f₁(t) /N, (f₁(t) /M) des dritten und vierten Signals (*V*₃,*V*₄) jeweils innerhalb des Frequenzbereichs des Korrelationsspektrums zu liegen kommen und bei Vorliegen einer Phasenabweichung zwischen den Phasen des ersten und zweiten Signals (V₁,V₂) die Phasen des ersten und zweiten Signals (V₁,V₂) durch Rücksetzen aller Kippstufen des ersten Frequenzteilers (100) zum Frequenzteilen des ersten Mess-Signals (V₁') und des zweiten Frequenzteilers zum Frequenzteilen des zweiten Mess-Signal (V₂') zueinander synchronisiert werden.

2. Verfahren zum Messen des Phasenrauschens nach Anspruch 1,
**dadurch gekennzeichnet,**
**dass** die erste Frequenz ((f₁+f₁(t))/N) des ersten Signals (V₁) und die zweite Frequenz ((f₁+f₁(t))/M) des zweiten Signals (V₂) eine identische Frequenz ist.

3. Verfahren zum Messen des Phasenrauschens nach Anspruch 1 oder 2,
**dadurch gekennzeichnet,**
**dass** die Phasen des ersten und zweiten Signals (V₁,V₂) bei einer positiven Flanke des ersten und zweiten Mess-Signals (V₁',V₂') synchronisiert werden.

4. Verfahren zum Messen des Phasenrauschens nach Anspruch 1 oder 2,
**dadurch gekennzeichnet,**
**dass** die Phasen des ersten und zweiten Signals (V₁,V₂) bei einer negativen Flanke des ersten und zweiten Mess-Signals (V₁',V₂') synchronisiert werden.

5. Verfahren zum Messen des Phasenrauschens nach Anspruch 1,
**dadurch gekennzeichnet,**
**dass** die erste Frequenz ((f₁+f₁(t))/N) des ersten Signals (V₁) und die zweite Frequenz ((f₁+f₁(t))/M) des zweiten Signals (V₂) eine unterschiedliche Frequenz ist.

6. Verfahren zum Messen des Phasenrauschens nach einem der Ansprüche 1 bis 5,
**dadurch gekennzeichnet,**
**dass** dem Ermitteln des Korrelationsspektrum ein zeitliches Mitteln zeitlich aufeinander folgender Korrelationsspektren nachfolgt.

7. Vorrichtung zum Messen des Phasenrauschens eines Mess-Signals (V) einer Signalquelle (100) mit einer bestimmten Mess-Frequenz (f₁) und mit einem überlagerten Phasenrauschen (f₁(t)),
mit einem Verteiler (105) zur Erzeugung eines ersten und zweiten Mess-Signals (V₁',V₂') aus dem Mess-Signal (V), mit einer ersten Einheit (200) zur Reduzierung der Mess-Frequenz (f₁) und des Phasenrauschens (f₁(t)) des ersten Mess-Signals (V₁') auf eine erste Frequenz ((f₁+f₁(t))/N) eines ersten Signals (V₁),
mit einer zweiten Einheit (210) zur Reduzierung der Mess-Frequenz (f₁) und des Phasenrauschens (f₁(t)) des zweiten Mess-Signals (V₂') auf eine zweite Frequenz ((f₁+f₁(t))/M) eines zweiten Signals (V₂),
mit einem ersten Phasenregelkreis (110) zur Ermittlung eines dritten Signals (V₃) mit einer gegenüber der ersten Frequenz ((f₁+f₁(t))/N) des ersten Signal (V₁) um die Meßfrequenz (f₁) kompensierten dritten Frequenz (f₃(t)), mit einem zweiten Phasenregelkreis (120) zur Ermittlung eines vierten Signals (V₄) mit einer gegenüber der zweiten Frequenz ((f₁+f₁(t))/M) des zweiten Signal (V₂) um die Meßfrequenz (f₁) kompensierten vierten Frequenz (f₄(t)) und
mit einem Korrelator (170) zur Bestimmung eines Korrelationsspektrums aus dem dritten und vierten Phasensignal (V₃,V₄),
**dadurch gekennzeichnet, dass** die erste und die zweite Einheit (200, 210) zur Reduzierung der Frequenz (f₁+f₁(t)) des ersten bzw. zweiten Mess-Signals (V₁',V₂') jeweils ein ein erster bzw. ein zweiter Frequenzteiler (200, 210) sind, die jeweils mindestens eine kaskadierte rückgekoppelte flankengesteuerte Kippstufe (240₁,240₂,...,240ₙ) mit Rücksetzmöglichkeit umfasst,
dass dem ersten und zweiten Frequenzteiler (200, 210) ein Phasenvergleicher (220) zum Vergleich der Phase des ersten Signals (V₁) am Ausgang des ersten Frequenzteilers (200) mit der Phase des zweiten Signals (V₂) am Ausgang des zweiten Frequenzteilers (210) und
dass dem Phasenvergleicher (220) eine Rücksetzlogik (230) zum synchronen Rücksetzen der im ersten und zweiten Frequenzteiler (200,210) jeweils kaskadierten flankengesteuerten Kippstufen (240₁,240₂,...,240ₙ) im Fall einer unterschiedlichen Phase des ersten und zweiten Signals (V₁,V₂) nachgeschaltet ist.

8. Vorrichtung zum Messen des Phasenrauschens eines Signals nach Anspruch 7,
**dadurch gekennzeichnet, dass** die Triggerung des ersten und zweiten Frequenzteilers (200,210) jeweils einstellbar bei einer positiven oder einer negativen Flanke des ersten bzw. zweiten Mess-Signals (V₁',V₂') am Eingang des ersten bzw. zweiten Frequenzteilers (200,210) erfolgt.

## Claims

1. Method for measuring the phase noise of a signal with the following method steps:
- detecting a measurement signal (V) with a certain measurement frequency (f₁) and with a superimposed phase noise (f₁(t)),
- dividing the measurement signal (V) into a first measurement signal (V₁') and a second measurement signal (V₂') in each case with the certain measurement frequency (f₁) and with the superimposed phase noise (f₁(t)),
- deriving a first signal (V₁) from the first measurement signal (V₁') with a first frequency ((f₁+f₁(t))/N) which is reduced in relation to the measurement frequency (f₁) and the superimposed phase noise (f₁(t)) by frequency reduction,
- deriving a second signal (V₂) from the second measurement signal (V₂') with a second frequency ((f₁+f₁(t))/M) which is reduced in relation to the measurement frequency (f₁) and the superimposed phase noise (f₁(t)) by frequency reduction,
- determining a third signal (*V*₃) with a third frequency (f₃(t)) which is compensated by the measurement frequency (f₁) in relation to the first frequency ((f₁+f₁(t))/N) of the first signal (V₁),
- determining a fourth signal (*V*₄) with a fourth frequency (f₄(t)) which is compensated by the measurement frequency (f₁) in relation to the second frequency ((f₁+f₁(t))/M) of the second signal (V₂),
- determining a correlation spectrum with a frequency range from the third and fourth signal (*V*₃, *V*₄),
**characterised in that**
the frequency reduction is effected by means of frequency division of the frequency (f₁+f₁(t)) of the first and second measurement signal (V₁', V₂') by a first and a second frequency divider (200, 210) respectively each of which has at least one cascaded feedback edge-controlled flip-flop circuit (240₁ to 240ₙ) so that the third and fourth frequency (f₁(t)/N, (f₁(t)/M) of the third and fourth signal (*V*₃, *V₄)* in each case come to lie within the frequency range of the correlation spectrum and in the case of a phase difference between the phases of the first and second signal (V₁, V₂) the phases of the first and second signal (V₁, V₂) are synchronised with one another by resetting all the flip-flop circuits of the first frequency divider (100) for frequency division of the first measurement signal (V₁') and of the second frequency divider for frequency division of the second measurement signal (V₂').

2. Method for measuring the phase noise according to claim 1,
**characterised in that** the first frequency ((f₁+f₁(t))/N) of the first signal (V₁) and the second frequency ((f₁+f₁(t))/M) of the second signal (V₂) is an identical frequency.

3. Method for measuring the phase noise according to claim 1 or 2, **characterised in that** the phases of the first and second signal (V₁, V₂) are synchronised with a positive edge of the first and second measurement signal (V₁', V₂').

4. Method for measuring the phase noise according to claim 1 or 2, **characterised in that** the phases of the first and second signal (V₁, V₂) are synchronised with a negative edge of the first and second measurement signal (V₁', V₂').

5. Method for measuring the phase noise according to claim 1,
**characterised in that** the first frequency ((f₁+f₁(t))/N) of the first signal (V₁) and the second frequency ((f₁+f₁(t))/M) of the second signal (V₂) is a different frequency.

6. Method for measuring the phase noise according to one of claims 1 to 5, **characterised in that** the determining of the correlation spectrum is followed by a time averaging of successive correlation spectra.

7. Device for measuring the phase noise of a measurement signal (V) of a signal source (100) with a certain measurement frequency (f₁) and with a superimposed phase noise (f₁(t)),
with a distributor (105) for producing a first and second measurement signal (V_{1'}, V₂') from the measurement signal (V),
with a first unit (200) for reducing the measurement frequency (f₁) and the phase noise (f₁(t)) of the first measurement signal (V₁') to a first frequency ((f₁+f₁(t))/N) of a first signal (V₁),
with a second unit (210) for reducing the measurement frequency (f₁) and the phase noise (f₁(t)) of the second measurement signal (V₂') to a second frequency ((f₁+f₁(t))/M) of a second signal (V₂),
with a first phase control circuit (110) for determining a third signal (V₃) with a third frequency (f₃(t)) which is compensated by the measurement frequency (f₁) in relation to the first frequency ((f₁+f₁(t))/N) of the first signal (V₁),
with a second phase control circuit (120) for determining a fourth signal (V₄) with a fourth frequency (f₄(t)) which is compensated by the measurement frequency (f₁) in relation to the second frequency ((f₁+f₁(t))/M) of the second signal (V₂), and
with a correlator (170) for determining a correlation spectrum from the third and fourth phase signal (V₃, V₄),
**characterised in that**
the first and the second unit (200, 210) for reducing the frequency (f₁+f₁(t)) of the first and second measurement signal (V₁', V₂') are respectively a first and a second frequency divider (200, 210) each of which comprises at least one cascaded feedback edge-controlled flip-flop circuit (240₁, 240₂,..., 240ₙ) which is capable of being reset, **in that** the first and second frequency divider (200, 210) is followed by a phase comparator (220) for comparing the phase of the first signal (V₁) at the output of the first frequency divider (200) with the phase of the second signal (V₂) at the output of the second frequency divider (210) and
**in that** the phase comparator (220) is followed by a reset logic (230) for synchronous resetting of the cascaded edge-controlled flip-flop circuits (240₁, 240₂, ..., 240ₙ) in the first and second frequency divider (200, 210) in the event of a different phase of the first and second signal (V₁, V₂).

8. Device for measuring the phase noise of a signal according to claim 7, **characterised in that** the triggering of the first and second frequency divider (200, 210) is in each case effected adjustably with a positive or a negative edge of the first or second measurement signal (V₁', V₂') at the input of the first or second frequency divider (200, 210) respectively.

## Revendications

1. Procédé de mesure du bruit de phase d'un signal, comprenant les étapes suivantes :
• détection d'un signal de mesure (V) ayant une fréquence de mesure définie (f₁) et un bruit de phase superposé (f₁(t)),
• division du signal de mesure (V) en un premier signal de mesure (V₁') et un deuxième signal de mesure (V₂') ayant chacun la fréquence de mesure définie (f₁) et le bruit de phase superposé (f₁(t)),
• dérivation d'un premier signal (V₁) à partir du premier signal de mesure (V₁'), ayant une première fréquence ((f₁+ f₁(t))/N) réduite par diminution de fréquence par rapport à la fréquence de mesure (f₁) et au bruit de phase superposé (f₁(t)),
• dérivation d'un deuxième signal (V₂) à partir du deuxième signal de mesure (V₂'), ayant une deuxième fréquence ((f₁+f₁(t))/M) réduite par diminution de fréquence par rapport à la fréquence de mesure (f₁) et au bruit de phase superposé (f₁(t)),
• détermination d'un troisième signal (*V*₃) ayant une troisième fréquence (f₃(t)) compensée de la fréquence de mesure (f₁) par rapport à la première fréquence ((f₁+f₁(t))/N) du premier signal (V₁),
• détermination d'un quatrième signal (*V*₄) ayant une quatrième fréquence (f₄(t)) compensée de la fréquence de mesure (f₁) par rapport à la deuxième fréquence ((f₁+f₁(t))/M) du deuxième signal (V₂),
• détermination d'un spectre de corrélation ayant une plage de fréquence à partir du troisième et du quatrième signal (*V*₃, *V*₄),
**caractérisé**
**en ce que** la diminution de fréquence est effectuée au moyen d'une division de la fréquence (f₁+f₁(t)) du premier et du deuxième signal de mesure (V₁',V₂') par un premier et un deuxième diviseur de fréquence (200, 210), qui présentent chacun au moins un étage de bascule (240₁ à 240ₙ) à déclenchement par flanc et rétrocouplé en cascade, de telle sorte que la troisième et la quatrième fréquence (f₁(t)/N, (f₁(t)/M) du troisième et du quatrième signal (*V*₃, *V*₄) viennent chacune à être comprises dans la plage de fréquence du spectre de corrélation et que, si un écart est présenté entre les phases du premier et du deuxième signal (V₁, V₂), les phases du premier et du deuxième signal (V₁, V₂) sont synchronisées entre elles par réinitialisation de tous les étages de bascule du premier diviseur de fréquence (100) pour la division de fréquence du premier signal de mesure (V₁'), et du deuxième diviseur de fréquence pour la division de fréquence du deuxième signal de mesure (V₂').

2. Procédé de mesure du bruit de phase selon la revendication 1,
**caractérisé**
**en ce que** la première fréquence ((f₁+f₁(t))/N) du premier signal (V₁) et la deuxième fréquence ((f₁+f₁(t))/M) du deuxième signal (V₂) sont identiques.

3. Procédé de mesure du bruit de phase selon la revendication 1 ou 2,
**caractérisé**
**en ce que** les phases du premier et du deuxième signal (V₁, V₂) sont synchronisées en cas de flanc positif du premier et du deuxième signal de mesure (V₁', V₂').

4. Procédé de mesure du bruit de phase selon la revendication 1 ou 2,
**caractérisé**
**en ce que** les phases des premier et deuxième signal (V₁, V₂) sont synchronisées en cas de flanc négatif du premier et du deuxième signal de mesure (V₁', V₂').

5. Procédé de mesure du bruit de phase selon la revendication 1,
**caractérisé**
**en ce que** la première fréquence (f₁+f₁(t))/N) du premier signal (V₁) et la deuxième fréquence ((f₁+f₁(t))/M) du deuxième signal (V₂) sont différentes.

6. Procédé de mesure du bruit de phase selon l'une des revendications 1 à 5,
**caractérisé**
**en ce que** le calcul de moyenne temporelle de spectres de corrélation successifs est consécutif à la détermination du spectre de corrélation.

7. Dispositif de mesure du bruit de phase d'un signal de mesure (V) d'une source de signal (100) ayant une fréquence de mesure définie (f₁) et un bruit de phase superposé (f₁(t)),
avec un diviseur (105) pour la génération d'un premier et d'un deuxième signal de mesure (V₁', V₂') à partir du signal de mesure (V),
avec une première unité (200) pour la réduction de la fréquence de mesure (f₁) et du bruit de phase (f₁(t)) du premier signal de mesure (V₁') à une première fréquence ((f₁+f₁(t))/N) d'un premier signal (V₁),
avec une deuxième unité (210) pour la réduction de la fréquence de mesure (f₁) et du bruit de phase (f₁(t)) du deuxième signal de mesure (V₂') à une deuxième fréquence ((f₁+f₁(t))/M) d'un deuxième signal (V₂),
avec un premier circuit de régulation de phase (110) pour la détermination d'un troisième signal (V₃) ayant une troisième fréquence (f₃(t)) compensé de la fréquence de mesure (f₁) par rapport à la première fréquence ((f₁+f₁(t))/N) du premier signal (V₁),
avec un deuxième circuit de régulation de phase (120) pour la détermination d'un quatrième signal (V₄) ayant une quatrième fréquence (f₄(t)) compensée de la fréquence de mesure (f₁) par rapport à la deuxième fréquence ((f₁+f₁(t))/M) du deuxième signal (V₂), et
avec un corrélateur (170) pour la détermination d'un spectre de corrélation à partir du troisième et du quatrième signal de phase (V₃, V₄),
**caractérisé**
**en ce que** la première et la deuxième unité (200, 210) pour la réduction de la fréquence (f₁+f₁(t)) du premier et du deuxième signal de mesure (V₁', V₂') sont respectivement un premier et un deuxième diviseur de fréquence (200, 210), qui présentent chacun au moins un étage de bascule (240₁, 240₂, ..., 240ₙ) à déclenchement par flanc et rétrocouplé en cascade, à possibilité de réinitialisation,
**en ce qu'**un comparateur de phase (220) pour la comparaison de la phase du premier signal (V₁) à la sortie du premier diviseur de fréquence (200) avec la phase du deuxième signal (V₂) à la sortie du deuxième diviseur de fréquence (210) est disposé en aval du premier et deuxième diviseur de fréquence (200, 210) et
**en ce qu'**une logique de réinitialisation (230) pour la réinitialisation synchrone des étages de bascule (240₁, 240₂, ..., 240ₙ) à déclenchement par flanc et disposés en cascade dans le premier et le deuxième diviseur de fréquence (200, 210) en cas de différence de phase entre le premier et le deuxième signal (V₁, V₂), est disposée en aval du comparateur de phase (220).

8. Dispositif de mesure du bruit de phase d'un signal selon la revendication 7,
**caractérisé**
**en ce que** le premier et le deuxième diviseur de fréquence (200, 210) respectivement sont déclenchés de manière réglable en cas de flanc positif ou négatif du premier et du deuxième signal de mesure (V₁', V₂') à l'entrée du premier et du deuxième diviseur de fréquence (200, 210).
